# EUROPÄISCHE PATENTSCHRIFT

(11) **EP 2 534 756 B1**
(45) Veröffentlichungstag und Bekanntmachung des Hinweises auf die Patenterteilung: **06.08.2014**
(21) Anmeldenummer: 11702950.4
(22) Anmeldetag: 21.01.2011
(51) Int. Cl.: H03F 3/26, H03F 3/28

(54) **GEGENTAKTVERSTÄRKER MIT INDUKTIVER GLEICHTAKTENTKOPPLUNG**
PUSH-PULL AMPLIFIER HAVING INDUCTIVE COMMON MODE DECOUPLING
AMPLIFICATEUR SYMÉTRIQUE À COUPLAGE INDUCTIF EN MODE COMMUN

(30) Priorität: 10.02.2010 DE 102010007451
(43) Veröffentlichungstag der Anmeldung: 19.12.2012
(73) Patentinhaber: Siemens Aktiengesellschaft, 80333 München (DE)
(72) Erfinder: HEID, Oliver, 91052 Erlangen (DE)
(86) Internationale Anmeldenummer: PCT/EP2011/050804
(87) Internationale Veröffentlichungsnummer: WO 2011/098336

(56) Entgegenhaltungen:
- JP-A- 1 269 305
- US-A- 2 201 345
- US-A- 2 509 389
- US-A- 4 167 709
- US-A- 5 477 188
- US-A1- 2003 179 815

## Beschreibung

Die vorliegende Erfindung betrifft einen Gegentaktverstärker zum Verstärken eines zu verstärkenden Eingangssignals zu einem Ausgangssignal,
- wobei der Gegentaktverstärker ein erstes und ein zweites Verstärkerelement aufweist,
- wobei jedes der Verstärkerelemente eine stromemittierende Elektrode, eine stromsammelnde Elektrode und eine stromsteuernde Elektrode aufweist,
- wobei den stromsteuernden Elektroden der Verstärkerelemente über einen jeweiligen Eingangsanschluss das Eingangssignal zugeführt wird,
- wobei die stromsammelnden Elektroden mit einer gemeinsamen Versorgungsspannung verbunden sind,
- wobei die stromemittierenden Elektroden der Verstärkerelemente über einen jeweiligen Kondensator mit der stromsammelnden Elektrode des jeweils anderen Verstärkerelements verbunden sind.

Derartige Gegentaktverstärker sind allgemein bekannt. Rein beispielhaft wird auf die US 2,201,345 A verwiesen.

Aus der US 1,964,048 A und der korrespondierenden deutschen Patentschrift 592 184 ist bekannt, zur Gleichtaktunterdrückung in ein Leitungspaar eine Spulenanordnung einzuschalten, die aus zwei ineinander gewickelten und somit eng miteinander gekoppelten gleichsinnigen Spulen besteht.

Zum Verstärken eines zu verstärkenden Eingangssignals ist bekannt, eine Halbbrückenschaltung zu verwenden, bei welcher die beiden aktiven Bauelemente (Transistoren, Röhren) in Serie geschaltet sind. Bei dieser Ausgestaltung muss das sogenannte "high-side-Bauteil" ein hohes Wechsel- und Gleichspannungspotenzial gegen Masse besitzen. Parasitäre Kapazitäten - beispielsweise vom Bauteilgehäuse gegen Masse - führen bei dieser Ausgestaltung in der Praxis eine Unsymmetrie in die Schaltung ein. Weiterhin gestaltet sich wegen der stark unterschiedlichen Streukapazitäten die symmetrische Ansteuerung der aktiven Bauelemente schwierig. Andere Ausführungsformen mit symmetrischem Massebezug der Bauelemente benötigen am Ausgang ein Leistungssymmetrier- und -kombinationsglied, beispielsweise einen Transformator.

Es sind auch Gegentaktverstärker bekannt, bei denen die aktiven und passiven Bauteile symmetrisch angeordnet sind. So sind beispielsweise entsprechende Schaltungen unter den für Fachleute üblichen Bezeichnungen "parallel push-pull", "circlotron" und Gegen-Halbbrückenschaltung bekannt, welche die Potenziale der aktiven Bauteile in der gewünschten Weise symmetrisieren. Allerdings werden bei diesen Schaltungen zwei getrennte Spannungsversorgungen benötigt. Weiterhin ist die Ansteuerung prinzipell mit jeweils der halben Ausgangsspannung überlagert, so dass die theoretisch maximale Spannungsverstärkung auf den Faktor 2 begrenzt ist und selbst dieser Wert in der Praxis oftmals nicht erreicht wird. Im Kilohertzfrequenzbereich wird eine sogenannte "Bootstrap-Schaltung" der Treiberstufe verwendet, um diese extrem starke Gegenkopplung abzumindern. Bei höheren Frequenzen ist diese Schaltung wegen des starken Störeinflusses von Streukapazitäten jedoch nicht verwendbar.

Aus der eingangs genannten US 2,201,345 ist ein symmetrisch aufgebauter Gegentaktverstärker bekannt, bei dem eine gemeinsame Spannungsversorgung vorhanden ist. Auch bei diesem Gegentaktverstärker ist die erreichbare Verstärkung jedoch auf den Wert Zwei begrenzt.

Die Aufgabe der vorliegenden Erfindung besteht darin, einen symmetrisch aufgebauten Gegentaktverstärker derart auszugestalten, dass er mit einem Verstärkungsfaktor betrieben werden kann, der nicht von vorneherein auf den Wert Zwei begrenzt ist.

Die Aufgabe wird durch einen Gegentaktverstärker mit den Merkmalen des Anspruchs 1 gelöst. Vorteilhafte Ausgestaltungen des erfindungsgemäßen Gegentaktverstärkers sind Gegenstand der abhängigen Ansprüche 2 bis 8.

Erfindungsgemäß ist vorgesehen, einen Gegentaktverstärker der eingangs genannten Art dadurch auszugestalten,
- dass zwischen den stromsteuernden Elektroden der Verstärkerelemente und den Eingangsanschlüssen jeweils eine Eingangsinduktivität angeordnet ist,
- dass die stromsammelnden Elektroden mit der gemeinsamen Versorgungsspannung über eine jeweilige Versorgungsinduktivität verbunden sind,
- dass die stromemittierenden Elektroden mit Ausgangsanschlüssen verbunden sind, an denen das Ausgangssignal abgreifbar ist,
- dass die stromemittierenden Elektroden über eine jeweilige Ausgangsinduktivität mit einem Referenzpotential verbunden sind und
- dass die Versorgungsinduktivitäten der Verstärkerelemente mit den Eingangsinduktivitäten und den Ausgangsinduktivitäten des jeweils anderen Verstärkerelements induktiv gekoppelt sind.

Durch die induktive Kopplung der Versorgungsinduktivitäten mit den Eingangsinduktivitäten des jeweils anderen Verstärkerelements wird erreicht, dass der Verstärkungsfaktor des jeweiligen Verstärkerelements erheblich größer als zwei sein kann. Durch die induktive Kopplung der Versorgungsinduktivität mit der Ausgangsinduktivität des jeweils anderen Verstärkerelements wird erreicht, dass die Gleichspannungsversorgung der Verstärkerelemente durch das Ansteuern der Verstärkerelemente nicht beeinflusst wird.

Es ist möglich, die Verstärkerelemente als Röhren auszubilden, beispielsweise als Trioden. Bevorzugt sind die Verstärkerelemente jedoch als Transistoren ausgebildet. Eine Ausbildung in Form von Bipolartransistoren ist hierbei zwar möglich, bevorzugt ist jedoch eine Ausbildung als Feldeffekttransistoren.

In einer möglichen Ausgestaltung des erfindungsgemäßen Gegentaktverstärkers ist vorgesehen, dass die induktive Kopplung der Versorgungsinduktivität des ersten Verstärkerelements mit der Eingangsinduktivität und der Ausgangsinduktivität des zweiten Verstärkerelements durch einen Symmetriertransformator bewirkt wird, der zugleich auch die induktive Kopplung der Versorgungsinduktivität des zweiten Verstärkerelements mit der Eingangsinduktivität und der Ausgangsinduktivität des ersten Verstärkerelements bewirkt. In diesem Fall ergibt sich ein konstruktiv einfacher Aufbau des Gegentaktverstärkers. Weiterhin kann in diesem Fall der Symmetriertransformator zugleich auch als Ausgangstransformator zur Impedanzanpassung des Ausgangssignals wirken.

In einer alternativen Ausgestaltung des erfindungsgemäßen Gegentaktverstärkers ist vorgesehen, dass die induktive Kopplung der Versorgungsinduktivität des ersten Verstärkerelements mit der Eingangsinduktivität und der Ausgangsinduktivität des zweiten Verstärkerelements und die induktive Kopplung der Versorgungsinduktivität des zweiten Verstärkerelements mit der Eingangsinduktivität und der Ausgangsinduktivität des ersten Verstärkerelements durch jeweils ein eigenes Koppelelement bewirkt werden. In diesem Fall sind die Ausgangssignale relativ zum Referenzpotenzial unbalanciert.

Die Koppelelemente können nach Bedarf ausgebildet sein. Vorzugsweise sind sie als Mantelwellensperren ausgebildet. Wenn das Eingangssignal eine vorbestimmte Eingangsfrequenz aufweist, können die Mantelwellensperren insbesondere als Lambda-viertel-Leitungen ausgebildet sein.

Weitere Vorteile und Einzelheiten ergeben sich aus der nachfolgenden Beschreibung von Ausführungsbeispielen in Verbindung mit den Zeichnungen. Es zeigen in Prinzipdarstellung:

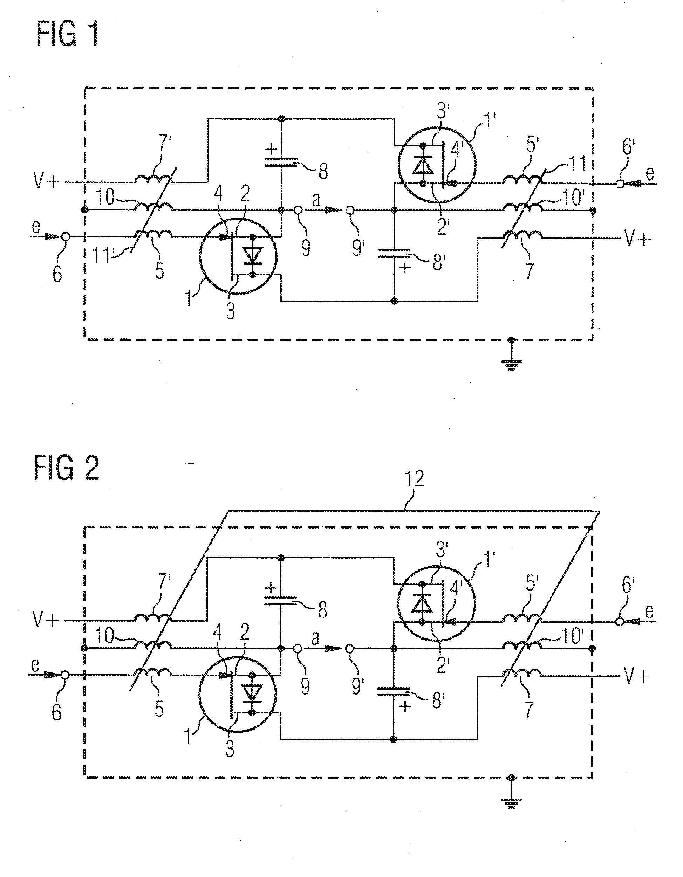

FIG 1 und 2 je einen Gegentaktverstärker.

Gemäß FIG 1 weist ein Gegentaktverstärker ein erstes und ein zweites Verstärkerelement 1, 1' auf. Jedes der beiden Verstärkerelemente 1, 1' weist eine stromemittierende Elektrode 2, 2', eine stromsammelnde Elektrode 3, 3' und eine stromsteuernde Elektrode 4, 4' auf.

Die Verstärkerelemente 1, 1' können als Röhren ausgebildet sein. In diesem Fall entsprechend die stromemittierenden Elektroden 2, 2' den Kathoden und die stromsammelnden Elektroden 3, 3' den Anoden der Röhren. Die stromsteuernden Elektroden 4, 4' sind in diesem Fall die Gitterelektroden.

Alternativ können die Verstärkerelemente 1, 1' als Transistoren in Form von Bipolartransistoren ausgebildet sein. In diesem Fall entsprechen die stromemittierenden Elektroden 2, 2'-den Emittern und die stromsammelnden Elektroden 3, 3' den Kollektoren der Transistoren. Die stromsteuernden Elektroden 4, 4' entsprechen in diesem Fall den Basen der Transistoren.

Entsprechend der in FIG 1 dargestellten bevorzugten Ausgestaltung sind die Verstärkerelemente 1, 1' als Feldeffekttransistoren ausgebildet. In diesem Fall entsprechen die stromemittierenden Elektroden 2, 2' den "Sources" und die stromsammelnden Elektroden 3, 3' den "Drains" der Feldeffekttransistoren. Die stromsteuernden Elektroden 4, 4' entsprechen den "Gates" der Feldeffekttransistoren.

Gemäß FIG 1 sind die stromsteuernden Elektroden 4, 4' der Verstärkerelemente 1, 1' über eine jeweilige Eingangsinduktivität 5, 5' mit einem jeweiligen Eingangsanschluss 6, 6' verbunden. Über den jeweiligen Eingangsanschluss 6, 6' wird den stromsteuernden Elektroden 4, 4' ein zu verstärkendes Eingangssignal e zugeführt.

Bei den Eingangsinduktivitäten 5, 5' handelt es sich um ganz normale Induktivitäten. Der Begriff "Eingangsinduktivitäten" wurde nur gewählt, um diese Induktivitäten von anderen Induktivitäten sprachlich unterscheiden zu können. Bei dem Eingangssignal e handelt es sich um ein Wechselspannungssignal. Es kann beispielsweise über in FIG 1 nicht dargestellte Einkoppelkondensatoren gleichspannungsmäßig vom Gegentaktverstärker entkoppelt sein.

Die stromsammelnden Elektroden 3, 3' sind über eine jeweilige Versorgungsinduktivität 7, 7' mit einer Versorgungsspannung V+ verbunden. Die Versorgungsspannung V+ ist eine gemeinsame Versorgungsspannung, die beide Verstärkerelemente 1, 1' mit elektrischer Energie versorgt. Bei der Versorgungsspannung V+ handelt es sich um eine Gleichspannung. Die Versorgungsspannung V+ ist entsprechend der Darstellung von FIG 1 positiv gegenüber Masse.

Die Versorgungsinduktivitäten 7, 7' sind - analog zu den Eingangsinduktivitäten 5, 5' - ganz normale Induktivitäten. Der Begriff "Versorgungsinduktivitäten" wurde nur gewählt, um diese Induktivitäten von anderen Induktivitäten sprachlich unterscheiden zu können.

Die stromemittierenden Elektroden 2, 2' der Verstärkerelemente 1, 1' sind gemäß FIG 1 über einen jeweiligen Kondensator 8, 8' mit den stromsammelnden Elektroden 3', 3 des jeweils anderen Verstärkerelements 1', 1 verbunden. Die stromemittierenden Elektroden 2, 2' sind gemäß FIG 1 weiterhin mit Ausgangsanschlüssen 9, 9' verbunden. Über die Ausgangsanschlüsse 9, 9' ist ein Ausgangssignal a abgreifbar. Das Ausgangssignal a ist gegenüber dem Eingangssignal e verstärkt. Ein Verhältnis von Ausgangssignal a zu Eingangssignal e kann größer als zwei sein.

Die stromemittierenden Elektroden 2, 2' sind weiterhin über eine jeweilige Ausgangsinduktivität 10, 10' mit einem Referenzpotenzial verbunden. Das Referenzpotenzial kann entsprechend der Darstellung von FIG 1 das Massepotenzial sein. Es kann sich aber alternativ auch um ein vom Massepotenzial verschiedenes Potenzial handeln.

Die Ausgangsinduktivitäten 10, 10' sind ganz normale Induktivitäten. Der Begriff "Ausgangsinduktivitäten" wurde nur gewählt, um diese Induktivitäten von den anderen Induktivitäten sprachlich unterscheiden zu können.

Wie in FIG 1 durch schräge Linien dargestellt, sind die Versorgungsinduktivitäten 7, 7' der Verstärkerelemente 1, 1' mit den Eingangsinduktivitäten 5', 5 und den Ausgangsinduktivitäten 10', 10 des jeweils anderen Verstärkerelements 1', 1 induktiv gekoppelt. Die Linien entsprechen daher Koppelelementen 11, 11', welche die entsprechende induktive Kopplung realisieren. Die Koppelelemente 11, 11' können beispielsweise jeweils als Transformatorkern ausgebildet sein, auf den die entsprechenden Induktivitäten 7, 5', 10' bzw. 7', 5, 10 gewickelt sind.

Die induktive Kopplung ist derart dimensioniert, dass die induzierten Spannungen sich gegenseitig kompensieren. Das Übersetzungsverhältnis sollte also möglichst nahe an Eins liegen. Die an den Ausgangsanschlüssen 9, 9' anstehenden Ausgangsspannungen sollten also möglichst 1:1 auf die stromsteuernden Elektroden 4, 4' der Verstärkerelemente 1, 1' und auf die mit dem Versorgungspotenzial V+ verbundenen Seiten der Kondensatoren 8, 8' rückgekoppelt werden.

Die Induktivitäten 5, 5', 7, 7', 10, 10' können entsprechend der Darstellung von FIG 1 zwei voneinander getrennte Dreiergruppen bilden. In diesem Fall wird die induktive Kopplung der Versorgungsinduktivität 7 des ersten Verstärkerelements 1 mit der Eingangsinduktivität 5' und der Ausgangsinduktivität 10' des zweiten Verstärkerelements 1' durch das Koppelelement 11 bewirkt. Die induktive Kopplung der Versorgungsinduktivität 7' des zweiten Verstärkerelements 1' mit der Eingangsinduktivität 5 und der Ausgangsinduktivität 10 des ersten Verstärkerelements 1 wird in diesem Fall durch das Koppelelement 11' bewirkt. Die Koppelelemente 11, 11' sind gemäß der Ausgestaltung von FIG 1 voneinander verschiedene Koppelelemente 11, 11'.

Die Koppelelemente 11, 11' können beispielsweise als Mantelwellensperren ausgebildet sein. Wenn das Eingangssignal e eine vorbestimmte Eingangsfrequenz aufweist (bzw. hinreichend schmalbandig ist), können die Mantelwellensperren beispielweise als Lambda-viertel-Leitungen ausgebildet sein.

Der Gegentaktverstärker von FIG 2 entspricht im Wesentlichen dem Gegentaktverstärker von FIG 1. Im Unterschied zum Gegentaktverstärker von FIG 1 wird jedoch bei dem Gegentaktverstärker von FIG 2 die induktive Kopplung der Induktivitäten 5, 5', 7, 7', 10, 10' durch einen (einzigen) Symmetriertransformator 12 bewirkt, auf den alle sechs genannten Induktivitäten 5, 5', 7, 7', 10, 10' gewickelt sind. In diesem Fall liegt zum einen das Referenzpotenzial auf dem Massepotenzial. Zum anderen wird in diesem Fall durch den Symmetriertransformator 12 nicht nur die induktive Kopplung der Versorgungsinduktivität 7 des ersten Verstärkerelements 1 mit der Eingangsinduktivität 5' und der Ausgangsinduktivität 10' des zweiten Verstärkerelements 1' bewirkt. Der Symmetrietransformator 12' bewirkt zugleich auch die induktive Kopplung der Versorgungsinduktivität 7' des zweiten Verstärkerelements 1' mit der Eingangsinduktivität 5 und der Ausgangsinduktivität 10 des ersten Verstärkerelements 1.

Ebenso wie im Stand der Technik kann sowohl bei der Ausgestaltung des Gegentaktverstärkers gemäß FIG 1 als auch bei der Ausgestaltung des Gegentaktverstärkers gemäß FIG 2 ein Ausgangstransformator vorhanden sein, mittels dessen eine Impedanzanpassung des Ausgangssignals a vorgenommen wird. Bei der Ausgestaltung des Gegentaktverstärkers gemäß FIG 1 muss der Ausgangstransformator als eigenständiges Bauteil ausgebildet sein. Dies ist selbstverständlich auch bei der Ausgestaltung des Gegentaktverstärkers gemäß FIG 2 möglich. Bei der Ausgestaltung des Gegentaktverstärkers gemäß FIG 2 ist es entsprechend der Darstellung von FIG 2 jedoch alternativ ebenso möglich, dass der Symmetriertransformator 12 zugleich auch als Ausgangstransformator zur Impedanzanpassung des Ausgangssignals a wirkt. In diesem Fall müssen lediglich auf ein und denselben Transformatorkern zusätzlich zu den Induktivitäten 5, 5', 7, 7', 10, 10' auch die Wicklungen des Ausgangstransformators aufgebracht werden.

Die vorliegende Erfindung weist viele Vorteile auf. Insbesondere löst sie die Symmetrierungsprobleme des Standes der Technik sowohl auf der Ansteuer- als auch auf der Ausgangsseite und entkoppelt die Ansteuersignale und die Gleichspannungsversorgung der beiden Verstärkerzweige von dem Gegentakt-Wechselspannungspotenzial des Ausgangs. Dadurch wird auch die im Stand der Technik für unvermeidbar gehaltene starke Gegenkopplung aufgehoben. Im Ergebnis sind dadurch Verstärkungsfaktoren des Gegentaktverstärkers möglich, die erheblich größer als zwei sind. In Versuchen wurden Verstärkungsfaktoren zwischen 10 und 100 erreicht.

Die obige Beschreibung dient ausschließlich der Erläuterung der vorliegenden Erfindung. Der Schutzumfang der vorliegenden Erfindung soll hingegen ausschließlich durch die beigefügten Ansprüche bestimmt sein.

### Bezugszeichenliste

- 1, 1': Verstärkerelemente
- 2, 2': stromemittierende Elektroden
- 3, 3': stromsammelnde Elektroden
- 4, 4': stromsteuernde Elektroden
- 5, 5': Eingangsinduktivitäten
- 6, 6': Eingangsanschlüsse
- 7, 7': Versorgungsinduktivitäten
- 8, 8': Kondensatoren
- 9, 9': Ausgangsanschlüsse
- 10, 10': Ausgangsinduktivitäten
- 11, 11': Koppelelemente
- 12: Symmetriertransformator

- a: Ausgangssignal
- e: Eingangssignal
- V+: Versorgungsspannung

## Patentansprüche

1. Gegentaktverstärker zum Verstärken eines zu verstärkenden Eingangssignals (e) zu einem Ausgangssignal (a),
- wobei der Gegentaktverstärker ein erstes und ein zweites Verstärkerelement (1, 1') aufweist,
- wobei jedes der beiden Verstärkerelemente (1, 1') eine stromemittierende Elektrode (2, 2'), eine stromsammelnde Elektrode (3, 3') und eine stromsteuernde Elektrode (4, 4') aufweist,
- wobei den stromsteuernden Elektroden (4, 4') der Verstärkerelemente (1, 1') über einen jeweiligen Eingangsanschluss (6, 6') und eine jeweilige zwischen dem jeweiligen Eingangsanschluss (6, 6') und der jeweiligen stromsteuernden Elektrode (4, 4') angeordnete Eingangsinduktivität (5, 5') das Eingangssignal (e) zugeführt wird,
- wobei die stromsammelnden Elektroden (3, 3') über eine jeweilige Versorgungsinduktivität (7, 7') mit einer gemeinsamen Versorgungsspannung (V+) verbunden sind,
- wobei die stromemittierenden Elektroden (2, 2') der Verstärkerelemente (1, 1') über einen jeweiligen Kondensator (8, 8') mit der stromsammelnden Elektrode (3', 3) des jeweils anderen Verstärkerelements (1', 1) verbunden sind,
- wobei die stromemittierenden Elektroden (2, 2') mit Ausgangsanschlüssen (9, 9') verbunden sind, an denen das Ausgangssignal (a) abgreifbar ist,
- wobei die stromemittierenden Elektroden (2, 2') über eine jeweilige Ausgangsinduktivität (10, 10') mit einem Referenzpotential verbunden sind,
- wobei die Versorgungsinduktivitäten (7, 7') der Verstärkerelemente (1, 1') mit den Eingangsinduktivitäten (5', 5) und den Ausgangsinduktivitäten (10', 10) des jeweils anderen Verstärkerelements (1', 1) induktiv gekoppelt sind.

2. Gegentaktverstärker nach Anspruch 1,
**dadurch gekennzeichnet,**
**dass** die Verstärkerelemente (1, 1') als Transistoren ausgebildet sind.

3. Gegentaktverstärker nach Anspruch 2,
**dadurch gekennzeichnet,**
**dass** die Transistoren als Feldeffekttransistoren ausgebildet sind.

4. Gegentaktverstärker nach Anspruch 1, 2 oder 3,
**dadurch gekennzeichnet,**
**dass** die induktive Kopplung der Versorgungsinduktivität (7) des ersten Verstärkerelements (1) mit der Eingangsinduktivität (5') und der Ausgangsinduktivität (10') des zweiten Verstärkerelements (1') durch einen Symmetriertransformator (12) bewirkt wird, der zugleich auch die induktive Kopplung der Versorgungsinduktivität (7') des zweiten Verstärkerelements (1') mit der Eingangsinduktivität (5) und der Ausgangsinduktivität (10) des ersten Verstärkerelements (1) bewirkt.

5. Gegentaktverstärker nach Anspruch 4,
**dadurch gekennzeichnet,**
**dass** der Symmetriertransformator (12) zugleich auch als Ausgangstransformator zur Impedanzanpassung des Ausgangssignals (a) wirkt.

6. Gegentaktverstärker nach Anspruch 1, 2 oder 3,
**dadurch gekennzeichnet,**
**dass** die induktive Kopplung der Versorgungsinduktivität (7) des ersten Verstärkerelements (1) mit der Eingangsinduktivität (5') und der Ausgangsinduktivität (10') des zweiten Verstärkerelements (1') und die induktive Kopplung der Versorgungsinduktivität (7') des zweiten Verstärkerelements (1') mit der Eingangsinduktivität (5) und der Ausgangsinduktivität (10) des ersten Verstärkerelements (1) durch jeweils ein eigenes Koppelelement (11, 11') bewirkt werden.

7. Gegentaktverstärker nach Anspruch 6,
**dadurch gekennzeichnet,**
**dass** die Koppelelemente (11, 11') als Mantelwellensperren ausgebildet sind.

8. Gegentaktverstärker nach Anspruch 7,
**dadurch gekennzeichnet,**
**dass** das Eingangssignal (e) eine vorbestimmte Eingangsfrequenz aufweist und dass die Mantelwellensperren als Lambda-viertel-Leitungen ausgebildet sind.

## Claims

1. Push-pull amplifier for amplifying an input signal (e) to be amplified to form an output signal (a),
- wherein the push-pull amplifier has a first and a second amplifier element (1, 1'),
- wherein each of the two amplifier elements (1, 1') has a current-emitting electrode (2, 2'), a current-collecting electrode (3, 3') and a current-controlling electrode (4, 4'),
- wherein the input signal (e) is fed to the current-controlling electrodes (4, 4') of the amplifier elements (1, 1') via a respective input terminal (6, 6') and a respective input inductance (5, 5') arranged between the respective input terminal (6, 6') and the respective current-controlling electrode (4, 4'),
- wherein the current-collecting electrodes (3, 3') are connected to a common supply voltage (V+) via a respective supply inductance (7, 7')
- wherein the current-emitting electrodes (2, 2') of the amplifier elements (1, 1') are connected to the current-collecting electrode (3', 3) of the respective other amplifier element (1', 1) via a respective capacitor (8, 8'),
- wherein the current-emitting electrodes (2, 2') are connected to output terminals (9, 9'), at which the output signal (a) can be tapped off,
- wherein the current-emitting electrodes (2, 2') are connected to a reference potential via a respective output inductance (10, 10'),
- wherein the supply inductances (7, 7') of the amplifier elements (1, 1') are inductively coupled to the input inductances (5', 5) and the output inductances (10', 10) of the respective other amplifier element (1', 1).

2. Push-pull amplifier according to Claim 1,
**characterized**
**in that** the amplifier elements (1, 1') are embodied as transistors.

3. Push-pull amplifier according to Claim 2,
**characterized**
**in that** the transistors are embodied as field effect transistors.

4. Push-pull amplifier according to Claim 1, 2 or 3,
**characterized**
**in that** the inductive coupling of the supply inductance (7) of the first amplifier element (1) to the input inductance (5') and the output inductance (10') of the second amplifier element (1') is effected by a balancing transformer (12), which at the same time also effects the inductive coupling of the supply inductance (7') of the second amplifier element (1') to the input inductance (5) and the output inductance (10) of the first amplifier element (1).

5. Push-pull amplifier according to Claim 4,
**characterized**
**in that** the balancing transformer (12) at the same time also acts as an output transformer for the impedance matching of the output signal (a).

6. Push-pull amplifier according to Claim 1, 2 or 3,
**characterized**
**in that** the inductive coupling of the supply inductance (7) of the first amplifier element (1) to the input inductance (5') and the output inductance (10') of the second amplifier element (1') and the inductive coupling of the supply inductance (7') of the second amplifier element (1') to the input inductance (5) and the output inductance (10) of the first amplifier element (1) are effected by a dedicated coupling element (11, 11') in each case.

7. Push-pull amplifier according to Claim 6,
**characterized**
**in that** the coupling elements (11, 11') are embodied as standing-wave traps.

8. Push-pull amplifier according to Claim 7,
**characterized**
**in that** the input signal (e) has a predetermined input frequency, and in that the standing-wave traps are embodied as quarter-wave lines.

## Revendications

1. Amplificateur symétrique pour l'amplification d'un signal (e) d'entrée à amplifier en un signal (a) de sortie,
- dans lequel l'amplificateur symétrique a un premier et un deuxième éléments (1, 1') d'amplificateur,
- dans lequel chacun des deux éléments (1, 1') d'amplificateur a une électrode (2, 2') émettant le courant, une électrode (3, 3') collectant le courant et une électrode (4, 4') commandant le courant,
- dans lequel le signal (e) d'entrée est envoyé aux électrodes (4, 4') commandant le courant des éléments (1, 1') d'amplificateur par une borne (6, 6') d'entrée respective et par une inductance (5, 5') d'entrée, montée entre la borne (6, 6') d'entrée respective et l'électrode (4, 4') commandant le courant respective,
- dans lequel les électrodes (3, 3') collectant le courant sont reliées à une tension (V+) d'alimentation commune par une inductance (7, 7') d'alimentation respective,
- dans lequel les électrodes (2, 2') émettant le courant des éléments (1, 1') d'amplificateur sont reliées par un condensateur (8, 8') respectif à l'électrode (3', 3) collectant le courant de respectivement l'autre élément (1', 1) d'amplificateur,
- dans lequel les électrodes (2, 2') émettant le courant sont reliées à des bornes (9, 9') de sortie auxquelles le signal (a) de sortie peut être prélevé,
- dans lequel les électrodes (2, 2') émettant le courant sont reliées à un potentiel de référence par une inductance (10, 10') de sortie respective,
- dans lequel les inductances (7, 7') d'alimentation des éléments (1, 1') d'amplificateur sont couplées par induction aux inductances (5', 5) d'entrée et aux inductances (10', 10) de sortie de respectivement l'autre élément (1', 1) d'amplificateur.

2. Amplificateur symétrique suivant la revendication 1,
**caractérisé**
**en ce que** les éléments (1, 1') d'amplificateur sont constitués sous la forme de transistors.

3. Amplificateur symétrique suivant la revendication 2, **caractérisé**
**en ce que** les transistors sont constitués sous la forme de transistors à effet de champ.

4. Amplificateur symétrique suivant la revendication 1, 2 ou 3,
**caractérisé**
**en ce que** le couplage inductif de l'inductance (7) d'alimentation du premier élément (1) d'amplificateur à l'inductance (5') d'entrée et à l'inductance (10') de sortie du deuxième élément (1') d'amplificateur est provoqué par un transformateur (10) de symétrie, qui provoque en même temps aussi le couplage par induction de l'inductance (7') d'alimentation du deuxième élément (1') d'amplificateur à l'inductance (5) d'entrée et à l'inductance (10) de sortie du premier élément (1) d'amplificateur.

5. Amplificateur symétrique suivant la revendication 4,
**caractérisé**
**en ce que** le transformateur (12) de symétrie agit aussi en même temps comme transformateur de sortie pour adapter l'impédance du signal (a) de sortie.

6. Amplificateur symétrique suivant la revendication 1, 2 ou 3,
**caractérisé**
**en ce que** le couplage par induction de l'inductance (7) d'alimentation du premier élément (1) d'amplificateur à l'inductance (5') d'entrée et à l'inductance (10') de sortie du deuxième élément (1') d'amplificateur et le couplage par induction de l'inductance (7') d'alimentation du deuxième élément (1') d'amplificateur à l'inductance (5) d'entrée et à l'inductance (10) de sortie du premier élément (1) amplificateur sont provoqués par respectivement un élément (11, 11') propre de couplage.

7. Amplificateur symétrique suivant la revendication 6,
**caractérisé**
**en ce que** les éléments (11, 11') de couplage sont constitués sous la forme de baluns.

8. Amplificateur symétrique suivant la revendication 7,
**caractérisé**
**en ce que** le signal (e) d'entrée a une fréquence d'entrée définie à l'avance et ce que les baluns sont constitués sous la forme de lignes quart d'onde.
